# EUROPÄISCHE PATENTSCHRIFT

(11) **EP 3 056 124 B1**
(45) Veröffentlichungstag und Bekanntmachung des Hinweises auf die Patenterteilung: **13.09.2017**
(21) Anmeldenummer: 16158428.9
(22) Anmeldetag: 21.03.2014
(51) Int. Cl.: A47J 43/07

(54) **DATENSPEICHERELEMENT**
DATA STORAGE ELEMENT
ÉLEMENT DE MEMOIRE DE DONNEES

(30) Priorität: 21.03.2013 DE 102013102919
(43) Veröffentlichungstag der Anmeldung: 17.08.2016
(62) Teilanmeldung aus: 14713793.9
(73) Patentinhaber: Vorwerk & Co. Interholding GmbH, 42275 Wuppertal (DE)
(72) Erfinder: Hackert, Georg, 44869 Bochum (DE); Jacobs, Carsten, 42477 Radevormwald (DE); Lang, Torsten, 42657 Solingen (DE)
(74) Vertreter: Müller, Enno

(56) Entgegenhaltungen:
- WO-A1-2008/112066
- US-A1- 2002 009 017
- US-A1- 2008 223 854

## Beschreibung

Die Erfindung betrifft ein Datenspeicherelement nach den Merkmalen des Oberbegriffes des Anspruches 1. Ein solches Datenspeicherelement ist aus der US 2002/0009017 A1 (Figuren 4 und 5) bekannt. Die aufgezeigte Aufgabe ist dadurch gelöst, dass die Unterseite des als Flachteil ausgebildeten Datenspeicherelementes im Querschnitt in eine Wandungskontur übergeht, die sich in einem stumpfen Winkel zu der Konturlinie der Unterseite erstreckt und dass auch die Oberseite randseitig in dem Querschnitt in eine sich nach unten erstreckende Wandungskontur übergeht, die in einem stumpfen Winkel zu der Konturlinie der Oberseite verläuft, wobei sich im Zusammentreffen der beiden Wandkonturlinien eine umlaufende Kante zum Ergreifen des Datenspeicherelementes ergibt.

Ein solches Datenspeicherelement ist in seiner technischen Funktion bevorzugt entsprechend einem üblichen USB-Stick ausgebildet. Es kann auch noch Zusatzfunktionen aufweisen, wie etwa eine Verschlüsselungseinrichtung, insbesondere durch einen hierfür in dem Datenspeicherelement vorgesehenen Kryptospeicher. Es können auch Bauelemente zur Ausgestaltung von Funkübertragungsmöglichkeiten zur Datenübermittlung an das Datenspeicherelement vorgesehen sein, etwa solche, wie sie zur Übertragung nach dem UMTS-Standard erforderlich sind.

Bei mit einer Küchenmaschine zur Datenübertragung zusammenwirkendem Datenspeicherelement kann in einem Ansichtskegel mit einem Kegelwinkel von 60° oder weniger, bezogen auf eine Kegelachse senkrecht zu einer Mittelebene des Datenspeicherelementes und den Flächenmittelpunkt durchsetzend, nur die Oberseite sichtbar sein. Die Ausbildung des Datenspeicherelementes als Flachteil ist dazu genutzt, das Datenspeicherelement gleichsam integrierend in die Außenfläche der Küchenmaschine im Zustand der Datenübertragung anzuordnen.

Zwar kann das Datenspeicherelement gegenüber einer umgebenden Außenfläche des Gehäuses im Bereich der Datenübertragungs-Schnittstelle der Küchenmaschine eine gewisse Erhebung darstellen. Eine Ausrichtung der Oberseite ist aber angepasst an die Ausrichtung der umgebenden Gehäusefläche.

Bezüglich der Küchenmaschine ist bevorzugt, dass die Datenübertragungs-Schnittstelle in einer Teil-Außenfläche ausgebildet ist, die gegenüber der umgebenden Außenfläche der Küchenmaschine zurückversetzt ist. Sie ist zum Inneren der Küchenmaschine hin versetzt. Durch die gebildete Teil-Außenfläche und deren Zurückversetzung ist zugleich bevorzugt eine Aufnahmemulde gebildet für das Datenspeicherelement oder für zumindest einen Teil des Datenspeicherelementes. Die Aufnahmemulde kann günstig zur Halterung des Datenspeicherelementes in einem mit der Küchenmaschine verbundenen Zustand beitragen. Das Datenspeicherelement schließt mit seiner Oberseite im mit der Küchenmaschine verbundenen Zustand mit der umgebenden Außenfläche der Küchenmaschine ab oder erhebt sich über diese.

Die Aufnahmemulde weist einen Muldenboden auf. Eine Erstreckung des Muldenbodens ist bevorzugt an die Erstreckung der umgebenden Außenfläche der Küchenmaschine angepasst. Es handelt sich insofern gleichsam um einen ebenflächig zum Inneren der Küchenmaschine hin versetzten Bereich der Außenfläche.

Die Mulde kann derart gebildet sein, dass das Datenspeicherelement zugleich im aufgenommenen Zustand durch eine Muldenwandung allein gehalten ist, dies zumindest so weit, dass es bei einer Freiheit von Erschütterungen nicht zu einem Herabfallen oder Ausfallen des Datenspeicherelementes aus der Mulde kommt, auch wenn die Teil-Außenfläche senkrecht oder in einem spitzen Winkel zu einer Senkrechten (wiederum bezogen auf eine übliche Aufstellungssituation der Küchenmaschine auf ebenem Untergrund) gebildet ist.

Bevorzugt ist jedoch, dass das Datenspeicherelement ohne zusätzliche Maßnahmen, wie nachstehend noch in weiterer Einzelheit erläutert, in der Mulde jedenfalls bei deren senkrechter oder nahezu senkrechter Ausrichtung hinsichtlich der Teil-Außenfläche, nicht gehalten ist, also keine Datenübertragung stattfinden kann.

Die Größe der Mulde hinsichtlich ihrer Flächenerstreckung kann bevorzugt derart gegeben sein, dass ein oder mehrere, mit einem Reinigungstuch beispielsweise überzogene Finger sich zum Reinigen über die Teil-Außenfläche bewegen können. Die Zurückversetzung ist bevorzugt gegenüber einer gedanklichen Fortsetzung der umgebenden Außenfläche in ihrem tiefsten Bereich um wenige Millimeter gegeben, beispielsweise 3 bis 20 mm.

Das Datenspeicherelement kann bevorzugt eine an die Mulde geometrisch angepasste Gestaltung aufweisen, bezüglich des im Kontaktzustand in die Mulde eingetauchten Bereiches, so dass sich im Wesentlichen über die gesamte in die Mulde im Kontaktzustand eingetauchte Oberfläche des Datenspeicherelementes ein Anlegen an die Muldenwandung ergibt. Der in die Mulde im Kontaktzustand eingetauchte Bereich ist bevorzugt allein durch die Unterseite des Datenspeicherelementes gegeben. Hierbei kann die Unterseite vollständig, teilweise, oder bevorzugt jedenfalls überwiegend, in die Mulde im Kontaktzustand eingetaucht sein.

Randseitig geht die Unterseite im Querschnitt in eine Wandungskontur über, die sich in einem stumpfen Winkel von beispielsweise 91 bis 160° zu der Konturlinie der Unterseite, jedenfalls der dem Randbereich zugeordneten Abschnitt der Konturlinie, erstreckt. Auch die Oberseite geht randseitig in dem genannten Querschnitt in eine sich nach unten erstreckende Wandungskontur über, die in gleicher Weise in einem stumpfen Winkel, beispielsweise 91 bis 160° zu der Konturlinie der Oberseite, jedenfalls in dem dem Rand zugeordneten Bereich, verläuft. Entsprechend ergibt sich im Zusammentreffen der beiden Wandkonturlinien, eine umlaufende Kante, die zum Ergreifen des Datenspeicherelementes günstig ist. Die Kante ist bezüglich einer Dicke des Datenspeicherelementes, gemessen in dem Querschnitt zwischen der Unterseite und der Oberseite, außermittig angeordnet, nämlich bevorzugt versetzt zu der Oberseite hin.

Die Mulde kann - bezogen auf einen Querschnitt - vom Muldenboden sich nach außen, zum Übergang in die umgebende Außenfläche des Gehäuses erstreckende Muldenwandungen aufweisen. Es kann sich um eine umlaufende und bevorzugt geschlossen ausgebildete Muldenwandung handeln. Eine Muldenwandung kann in ihrer Erstreckung - bezogen auf den Querschnitt - bevorzugt einen stumpfen Winkel mit dem Muldenboden einschließen, weiter bevorzugt zwischen 91 und 160°.

Das Datenspeicherelement kann sich ergänzend zu Vorstehendem auch dadurch auszeichnen, dass es als Flachteil mit einer Unterseite und einer Oberseite ausgebildet ist, mit einer größten Grundrissabmessung der Unterseite beziehungsweise der Oberseite, die dem 1,5-Fachen oder mehr, bis hin zu 10- oder 20-Fachen, einer größten Dicke des Datenspeicherelementes entspricht und dass die Kontaktelemente in einer der Seiten, in der Unterseite, angeordnet sind.

Die untere Seite ist entsprechend die Seite, die im Zusammenwirkungszustand mit der Küchenmaschine unmittelbar auf einer entsprechenden Fläche, bevorzugt der genannten Teil-Außenfläche, aufliegt. Die flache Ausbildung, bevorzugt auch mit einem abgerundeten oder weiter bevorzugt mit einem kreisförmigen Grundriss, mit der Anordnung der Kontaktelemente in einer der Flachseiten, ermöglicht eine Handhabung durch einfaches Auflegen der vergleichsweise großen Unterseite auf die entsprechende Auflagefläche, insbesondere die Teil-Außenfläche, der Küchenmaschine. Es muss kein Einsteckvorgang vorgenommen werden.

Hinsichtlich der elektromotorisch betreibbaren Küchenmaschine ist bevorzugt in weiterer Ausgestaltung vorgesehen, dass die Teil-Außenfläche geschlossen ausgebildet ist. Es handelt sich um eine insbesondere öffnungs- und lochfreie Teil-Außenfläche.

Die Teil-Außenfläche kann insbesondere im Bereich der metallischen Kontaktelemente eine gewisse Erhebung oder Versenkung aufweisen. Die metallischen Kontaktelemente können sich hierbei über einen umgebenden Bereich der Teil-Außenfläche (gegebenenfalls auch als Muldenboden anzusprechen) nach außen um ein ihrer größten Erstreckung entsprechendes Maß oder weniger erheben oder um ein solches Maß gegenüber der Ebene beziehungsweise dem die metallischen Kontaktelemente umgebenden Bereich (gegebenenfalls auch als Muldenboden anzusprechen) zurückversetzt sein. Absolut kann das Maß beispielsweise zwischen 0,5 und 5 mm liegen. Im Falle einer Erhebung ist dieses aber bevorzugt geringer als es einer absoluten Versetzung (nach innen) der Teil-Außenfläche entspricht.

Die metallischen Kontaktelemente sind bevorzugt zusammengefasst in einer rippenartigen Erhöhung des Muldenbodens angeordnet.

Sie können sich auch in der Ebene der Teil-Außenfläche beziehungsweise zumindest des unmittelbar umgebenden Bereiches (im Falle etwa der genannten Rippenausbildung) erstrecken.

Im Einzelnen können drei oder mehr metallische Kontaktelemente vorgesehen sein. Hierbei ist auch bevorzugt, dass diese metallischen Kontaktelemente entlang einer Geraden angeordnet sind. Dies kann sowohl an der Küchenmaschine wie an dem Datenspeicherelement entsprechend vorgesehen sein. Bevorzugt sind die Ausbildungen betreffend die Kontaktelemente, die Anlagefläche und/oder die Mulde ohnehin gleichsam spiegelbildlich an der Küchenmaschine beziehungsweise dem Datenspeicherelement vorgesehen.

Die Teil-Außenfläche weist einen Flächenmittelpunkt auf, der auch als geometrischer Schwerpunkt bezeichnet wird. Bei einer kreisförmigen Teil-Außenfläche, deren Grundriss entsprechend durch eine Kreislinie begrenzt ist, ist der Flächenmittelpunkt der Mittelpunkt dieses Kreises.

Bezüglich eines solchen Flächenmittelpunktes ist bevorzugt, dass die metallischen Kontaktelemente außerhalb des Flächenmittelpunktes angeordnet sind. Bei einer kreisförmigen Grundrisskontur können die metallischen Kontaktelemente auf einer eine Sekante zu der diesbezüglichen Kreisfläche bildenden Linie angeordnet sein.

Die Teil-Außenfläche weist bevorzugt zumindest eine Rundungen aufweisende Grundrisskontur auf. Sie kann, wie angemerkt, im Speziellen kreisförmig oder beispielsweise oval sein.

Die Teil-Außenfläche ist gegenüber der Gesamt-Außenfläche der Küchenmaschine beziehungsweise einer Seite der Küchenmaschine, in welche sie integriert ist, vergleichsweise klein. Absolut gesehen, kann die Teil-Außenfläche eine Dimension aufweisen, bei welcher eine größte lineare Erstreckung, gegebenenfalls ein Durchmessermaß, innerhalb der Grundrisskontur 1 bis 10 cm beträgt.

Weiter bevorzugt sind ein oder mehrere in der Außenfläche oder in der Teil-Außenfläche wirksame Magnete oder magnetisierbare Bereiche vorgesehen. Ein Magnet oder magnetisierbarer Bereich kann seitlich versetzt zu einem metallischen Kontaktelement vorgesehen sein. Bevorzugt sind sie seitlich versetzt zu einer gedachten Verbindungslinie der Kontaktelemente zum Flächeninneren beziehungsweise zum Flächenmittelpunkt der Teil-Außenfläche hin. Insbesondere ist bevorzugt, dass ein Magnet oder ein magnetisierbare Bereich unterhalb der Teil-Außenfläche, jedoch in dieser wirkend, angeordnet ist, weiter bevorzugt derart, dass er von außen nicht sichtbar ist. Während die Teil-Außenfläche, wie auch die Außenfläche der Küchenmaschine bevorzugt im Übrigen, oder jedenfalls im Wesentlichen im Übrigen, aus Kunststoff gebildet ist, ist natürlicherweise der Magnet oder der magnetisierbare Bereich metallisch ausgebildet.

Insbesondere ist bevorzugt, dass zwei Magnete oder zwei magnetisierbare Bereiche vorgesehen sind.

Ein Abstand zwischen den Magneten oder den magnetisierbaren Bereichen ist bevorzugt größer als ein Abstand zwischen zwei äußersten von nebeneinander angeordneten metallischen Kontaktelementen. Insbesondere sind die Magnete oder magnetisierbaren Bereiche nahe an oder teilweise zusammenfallend mit einer Grundrisskontur der Teil-Außenfläche angeordnet. Im Hinblick auf ein hierin anordbares Datenspeicherelement ergibt sich so, bezogen auf die Gesamtfläche, eine größtmögliche "Hebelwirkung" zur Ausrichtung des Datenspeicherelementes beim Einsetzen.

Die Teil-Außenfläche weist in einem Querschnitt bevorzugt einen ebenflächigen Bodenbereich und ansteigende Randbereiche auf, wobei die Randbereiche weiter bevorzugt einer Krümmungslinie, beispielsweise einer Teil-Kreislinie folgend, ausgebildet sind. Auch der Übergang in die umgebende Außenfläche der Küchenmaschine ist bevorzugt gerundet ausgebildet.

Hinsichtlich des Datenspeicherelementes ist weiter bevorzugt, dass die umgebende Anlagefläche, in welcher die Kontaktflächen ausgebildet sind, praktisch höhengleich zu den Kontaktflächen ist. Im Einzelnen können die Kontaktflächen auch leicht versetzt, bevorzugt im Sinne einer Vertiefung, gegenüber der umgebenden Anlagefläche angeordnet sein. Die Versenkung kann hierbei im absoluten Maß etwa 0,5 bis 5 mm entsprechen.

Das Datenspeicherelement selbst weist hinsichtlich der Anlagefläche, die im Zusammenhang vorliegender Anmeldung auch als Unterseite bezeichnet ist, bevorzugt eine gerundete Kontur auf, beispielsweise eine kreisförmige oder ovalförmige Kontur. Hierbei ist die Anlagefläche, gegebenenfalls mit Ausnahme der Kontaktelemente, soweit diese der Anlagefläche gegenüber in der beschriebenen Weise erhaben oder versenkt angeordnet ausgebildet sind, ebenflächig gestaltet, mit einem Randbereich, der im Querschnitt gerundet verläuft, und zwar derart, dass der ebenflächige Bereich der Anlagefläche vorstehend ist. Die Ausmaße der Anlagefläche entsprechen den vorstehend angegebenen Ausmaßen der Teil-Außenfläche. Das Datenspeicherelement ist in Erstreckungsrichtung der Anlagefläche bevorzugt deutlich größer als quer hierzu. Es ist weiter bevorzugt als diskusartiger Körper gestaltet, wobei mit dieser Bezeichnung aber nicht zwingend eine kreisförmige Grundrisskontur vorgegeben ist. Die größte Dicke des Datenspeicherelementes entspricht bevorzugt einem Drittel bis einem Zwanzigstel der größten linearen Erstreckung bezogen auf eine Grundrisskontur des Datenspeicherelementes, bei dem ein Zustand abgenommen ist, bei welchem das Datenspeicherelement auf der Anlagefläche aufliegend auf einem ebenen Untergrund angenommen ist.

Das Datenspeicherelement kann einen nicht flüchtigen Speicher aufweisen. Es kann weiter einen Kryptospeicher aufweisen. Es kann darüber hinaus Elemente zur drahtlosen Datenübertragung, etwa Funkübertragung, aufweisen, so beispielsweise Elemente, wie sie für einen UMTS-Empfang erforderlich sind.

Eine Griffausformung des Datenspeicherelementes ergibt sich durch die Randkontur des Datenspeicherelementes. Hierzu ist die Unterseite so ausgebildet, dass die durch den Übergang der Unterseite in die Oberseite gegebene Randkontur im Zusammenwirkungszustand des Datenspeicherelementes mit der Küchenmaschine über die Außenfläche der Küchenmaschine übersteht, so dass das Datenspeicherelement hierzu greifbar ist.

Im Weiteren ist von Bedeutung, dass durch die versetzte Anordnung der Magnete/magnetisierbaren Bereiche relativ zu den Kontaktelementen, insbesondere bezüglich der im Einzelnen in einem erhabenen beziehungsweise versenkten Bereich angeordneten Kontaktelemente sich ein Einfang-Effekt des Datenspeicherelementes auf der Außenfläche, insbesondere in der Mulde, ergibt, so dass zur Zusammenfügung von Datenspeicherelement und Küchenmaschine im Hinblick auf einen Datenaustausch ein Benutzer nur eine grobe Vorausrichtung des Datenspeicherelementes bezüglich der Außenfläche beziehungsweise der Teil-Außenfläche der Küchenmaschine vornehmen muss und sich das Datenspeicherelement sodann durch die Magnetwirkung einerseits und eine zentrierende Einfügung des rippenartigen Vorsprungs in die entsprechende Ausnehmung andererseits selbst in die tatsächliche Kontaktposition manövriert. Hierzu ist es auch bevorzugt, dass der genannte rippenartige Vorsprung beziehungsweise die entsprechende Ausnehmung auf der Küchenmaschine, beziehungsweise in dem Datenspeicherelement, im Querschnitt gerundete Übergänge, mit einem stumpfen Winkel zwischen der unmittelbar umgebenden Außenfläche (Teil-Außenfläche) und einem Querschnittsverlauf der Wandung des rippenartigen Vorsprungs (analog bei der Ausnehmung) aufweisen. Der stumpfe Winkel kann zwischen 91 und 160° betragen. Bevorzugt ist bezüglich des rippenartigen Vorsprungs und der Ausnehmung ein solcher Winkel sowohl an den längsrandseitigen ansteigenden Flächen des rippenartigen Vorsprungs wie an den stirnseitigen Flächen des rippenartigen Vorsprungs ausgebildet.

Durch die in der Fläche versetzte Anordnung der Magnete beziehungsweise der magnetisierbaren Bereiche, einerseits, und dem rippenartigen Vorsprung oder die entsprechende Einsenkung, andererseits, ergibt sich beim ungerichteten Anlegen des Datenspeicherelementes an den entsprechenden Bereich der Küchenmaschine eine gewisse Einweiser-Hebelwirkung, die dann selbsttätig das Datenspeicherelement in die letztlich präzise Kontaktstellung zieht beziehungsweise bewegt.

Das Datenspeicherelement weist bevorzugt mit Ausnahme der beschriebenen nebeneinander angeordneten, jeweils einen Teil der Außenfläche bildenden Kontaktelemente keine weiteren in der Außenfläche liegenden oder von der Außenfläche ausgehenden (etwa nachstehend beschriebene übliche USB-Schnittstellen) Kontaktelemente auf.

Im Hinblick auf das Datenspeicherelement kann aber auch vorgesehen sein, dass es zusätzlich zu den beschriebenen, in der Außenfläche angeordneten Kontaktelementen - in einer der aufgezeigten Ausgestaltungen - als weitere Kontaktelemente solche einer üblichen USB-Schnittstelle aufweist. Eine solche USB-Schnittstelle ist lochartig in das Innere des Datenspeicherelements gerichtet. Die so gegebenenfalls vorgesehene übliche USB-Schnittstelle kann in einer Seitenfläche ausgebildet sein. Die Seitenfläche ist hierbei die zwischen den Ebenen der Unterseite und Oberseite ausgebildete Fläche. Hinsichtlich der bevorzugt im Grundriss kreisrunden Gestaltung des Datenspeicherelementes kann diese USB-Schnittstelle entsprechend nahezu beliebig am Umfang vorgesehen sein. Es können auch mehrere derartige übliche USB-Schnittstellen in beispielsweise der genannten Seitenfläche vorgesehen sein.

Darüber hinaus kann diese USB-Schnittstelle, gerichtet in das Innere des Datenspeicherelementes, auch ausgehend von der Ober- und/oder Unterseite vorgesehen sein. Auch können grundsätzlich mehrere übliche USB-Schnittstellen in dieser Weise ausgebildet sein.

Um ein Verschmutzungsproblem so gering wie möglich zu halten, kann eine solche übliche USB-Schnittstelle mit einem Verschlussteil versehen sein, etwa einem Verschlussteil, das stopfenartig ausgebildet ist. Weiter bevorzugt auch mit einem Verschlussteil, das mit einem gesonderten Werkzeug (nur) öffenbar ist.

Eine solche übliche USB-Schnittstelle kann dazu dienen, im ausgewählten Betriebszustand, beispielsweise insbesondere dann, wenn das Datenspeicherelement nicht mit der Küchenmaschine verbunden ist, dieses zur Übertragung von Daten an einen üblichen Rechner, etwa einen Standcomputer oder tragbaren Computer oder einen Tablett-Computer anzuschließen.

Die genannte übliche USB-Schnittstelle kann in weiterer Einzelheit eine Standard USB-Schnittstelle sein. Hierzu kennt man beispielsweise die Schnittstelle USB 2.0 Standard-A, die Schnittstelle USB 3.0 Standard-A, die Schnittstelle 3.0 Powered-B, die Schnittstelle USB 3.0 Standard-B, die Schnittstelle USB 2.0 Standard-B, die Schnittstelle USB 2.0 Mini-B, die Schnittstelle USB 3.0 Micro-AB, die Schnittstelle USB 2.0 Micro-AB, die Schnittstelle USB 3.0 Micro-B, die Schnittstelle USB 2.0 Micro-B etc.

Die vor- und nachstehend angegebenen Bereiche beziehungsweise Wertebereiche oder Mehrfachbereiche schließen hinsichtlich der Offenbarung auch sämtliche Zwischenwerte ein, insbesondere in 1/10- Schritten der jeweiligen Dimension, gegebenenfalls also auch dimensionslos; beispielsweise beträgt ein Schritt ein Zehntel einer Länge, Breite etc. oder eines x-Fachen; wenn weiter beispielsweise ein Bereich (für eine Länge) mit einem drei bis fünffachen (einer Breite) angegeben ist, ist auch offenbart das 3,1- bis 5-Fache, das 3- bis 4,9-Fache, das 3,1- bis 4,9-Fache, das 3,2- bis 5-Fache etc., d.h. einerseits zur Eingrenzung der genannten Bereichsgrenzen von unten und/ oder oben, alternativ oder ergänzend aber zur Offenbarung eines oder mehrerer singulärer Werte aus einem jeweils angegebenen Bereich. Bezüglich beispielsweise eines Bereiches von 0,5 bis 5 mm (Länge, Breite etc.) ist dann auch offenbart, 0,6 bis 5 mm, 0,6 bis 4,9 mm, 0,5 bis 4,9 mm etc. Bezüglich eines Winkelbereiches von beispielsweise 91 bis 160° ist somit auch ein Bereich von 91,1 bis 160°, 91 bis 159,9°, 91,1 bis 159,9° etc. offenbart, sowie auch diesbezügliche Einzelwerte als Bereichsgrenzen oder innerhalb des Bereiches.

Nachstehend ist die Erfindung des Weiteren anhand der beigefügten Zeichnung, die jedoch lediglich ein Ausführungsbeispiel darstellt, erläutert. Hierbei zeigt:
- Fig. 1: eine perspektivische Gesamtansicht einer Küchenmaschine mit zugeordnetem Datenspeicherelement;
- Fig. 2: den Bereich der Teil-Außenfläche in Vergrößerung;
- Fig. 3: eine Darstellung gemäß Figur 2, mit eingesetztem Datenspeicherelement;
- Fig. 4: einen Querschnitt durch die Küchenmaschine geschnitten entlang der Linie IV-IV in Figur 3;
- Fig. 5: eine perspektivische Ansicht des Datenspeicherelementes, gesehen auf die Unterseite;
- Fig. 6: eine Querschnittsdarstellung des Datenspeicherelementes, geschnitten entlang der Linie VI-VI in Figur 5;
- Fig. 7: eine Explosionsdarstellung des Datenspeicherelementes, gesehen von schräg oben;
- Fig. 8: eine Explosionsdarstellung des Datenspeicherelementes, gesehen von schräg unten; und
- Fig. 9: eine Darstellung des Datenspeicherelementes entsprechend Figur 6, mit angedeuteten einer oder mehreren zusätzlichen üblichen USB-Schnittstellen.

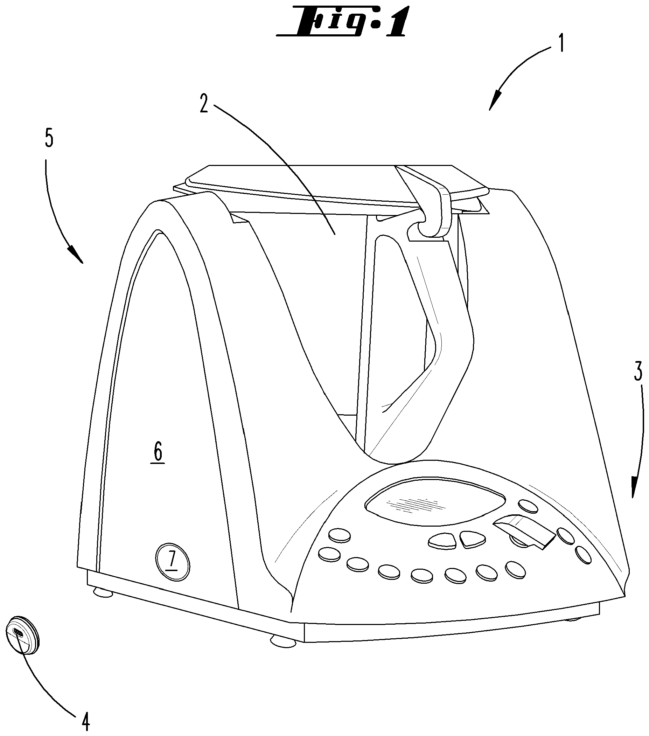

Dargestellt und beschrieben ist eine Küchenmaschine 1, die über einen nicht dargestellten, innerhalb der Küchenmaschine 1 befindlichen Elektromotor betreibbar ist. Die Küchenmaschine 1 weist weiter ein darin aufnehmbares, bei der Darstellung der Figur 1 aufgenommenes, Rührgefäß 2 auf und ein Bedienfeld 3.

Weiter ist in der Küchenmaschine 1 eine Steuerungseinrichtung vorgesehen für ein innerhalb des Rührgefäßes 2 betreibbares Rührwerk, und bevorzugt eine Aufheizeinrichtung zum Aufheizen des Rührgefäßes 2.

Weiter weist die Küchenmaschine einen Datenspeicher auf und einen Mikroprozessor. Darüber hinaus ist bevorzugt noch ein weiterer Datenspeicher vorgesehen, zur Aufnahme von Daten, die über ein Datenspeicherelement eingebracht werden können. Das Datenspeicherelement 4 ist lösbar an der Küchenmaschine 1 halterbar. In Figur 1 ist das Datenspeicherelement 4 losgelöst von der Küchenmaschine und gesehen auf die nachstehend als Unterseite angesprochene Fläche dargestellt. Eine Datenübertragung von dem Datenspeicherelement 4 ist zunächst bevorzugt in dem genannten weiteren Datenspeicher der Küchenmaschine vorgesehen. Ergänzend oder alternativ auch in dem zunächst genannten in der Küchenmaschine ohnehin vorhandenen Datenspeicher.

Im Einzelnen weist die Küchenmaschine 1 ein Gehäuse 5 auf, mit einer Außenfläche 6. In weiterer Einzelheit ergeben sich bei strenger Betrachtung der Küchenmaschine von vorne, hinten und der Seite, vier zu unterscheidende Außenflächen 6. In einer der Außenflächen 6, hier bevorzugt einer Seiten-Außenfläche, ist eine Teil-Außenfläche 7 ausgebildet. Die Teil-Außenfläche 7 stellt einen gegenüber der umgebenden Außenfläche 6 zum Inneren der Küchenmaschine 1 hin versetzten Bereich dar. Ersichtlich ist die Teil-Außenfläche 7 gegenüber der umgebenden Außenfläche 6 klein. Sie entspricht weniger als der Hälfte, bevorzugt weniger als einem Drittel, weiter bevorzugt weniger als einem Zehntel der umgebenden Außenfläche 6, hierbei bezogen auf eine Seitenfläche im angegebenen Sinne, beispielsweise bis hin zu einem Fünfzigstel.

Eine Seiten-Außenfläche der Küchenmaschine ist insbesondere eine Fläche, die sich in der weiter vorne beschriebenen Weise auf eine gedachte vertikale Fläche im Hinblick auf eine nach üblichen Zeichenregeln gefertigte Ansicht projizieren lässt. Hinsichtlich einer Oberseite einer Küchenmaschine handelt es sich entsprechend um eine darüber befindliche horizontale (gedachte) Fläche.

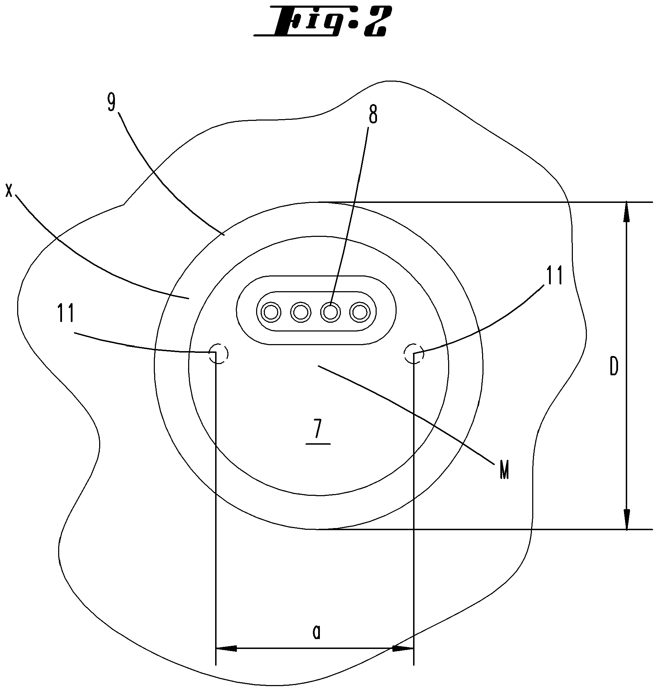

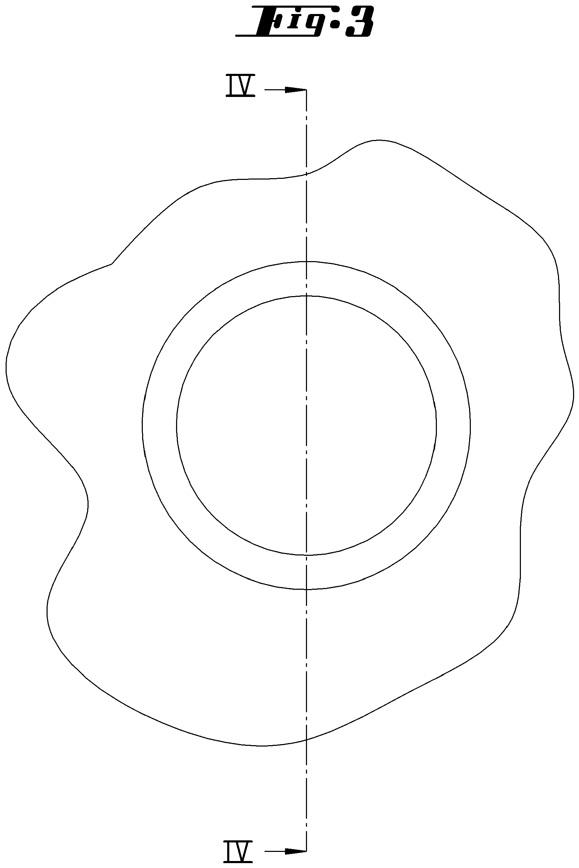

Die Teil-Außenfläche 7 ist mit Ausnahme eines Übergangsbereiches x in die umgebende Außenfläche 6 ebenflächig ausgebildet. Eine weitere Ausnahme können hierbei metallische Kontaktelemente 8 bilden, vergleiche Figur 2 beziehungsweise Figur 3. Die Teil-Außenfläche 7 ist gegenüber der genannten Außenfläche 6 der Küchenmaschine zurückversetzt. Innerhalb der Teil-Außenfläche 7 bilden die metallischen Kontaktelemente 8 einen Bereich dieser Teil-Außenfläche aus.

Die Teil-Außenfläche 7 ist bevorzugt als abgeschlossener Bereich ausgebildet. Dies ergibt sich beim Ausführungsbeispiel insbesondere durch eine geschlossen verlaufende Randkonturlinie 9. Die Randkonturlinie 9 muss nicht notwendig einer tatsächlichen Kante im Gehäuse entsprechen. Bevorzugt ist sie durch eine Kante gebildet. Sie kann etwa auch durch einen gerundeten Übergang (im Querschnitt) in die umgebende Außenfläche 6, also einer Sichtkante entsprechend, gegeben sein.

Die Teil-Außenfläche 7 ist weiter bevorzugt, wie sich insbesondere auch aus der Querschnittsdarstellung der Figur 3 ergibt, in einer Tiefenrichtung, zum Inneren der Küchenmaschine hin, geschlossen ausgebildet. Sie weist keine Durchbrüche, Öffnungen oder Vertiefungen in Richtung auf das Innere der Küchenmaschine auf. Sie stellt somit eine im Wesentlichen glatte, leicht reinigbare Fläche dar. Dem steht auch nicht entgegen, wenn die Kontaktelemente, wie nachstehend in weiterer Einzelheit erläutert, demgegenüber nochmals leicht angehoben oder abgesenkt angeordnet sind.

Die metallischen Kontaktelemente 8 sind zwar innerhalb der Absenkung der Teil-Außenfläche 7 angeordnet; gegenüber dem ebenflächigen Boden 10 der Teil-Außenfläche 7, der auch als Muldenboden angesprochen sein kann, sind sie jedoch bevorzugt leicht erhöht angeordnet.

Sie können auch ebenengleich oder etwas versenkt zu dem Boden 10 angeordnet sein, wie weiter vorne erläutert. Die Erhöhung ist bevorzugt (nur) in dem Maße, dass sie sich zwar erhöht zu dem umgebenden Bereich des Bodens 10 erstrecken, jedoch unterhalb der Randkonturlinie 9 beziehungsweise unterhalb eines umgebenden Flächenbereiches f der Außenfläche 6. Die Erhöhung ist in weiterer Einzelheit rippenartig gebildet. Die Kontaktflächen bilden Teilbereiche einer Stirnfläche einer solchen rippenartigen Erhöhung.

Es sind insgesamt bevorzugt vier metallische Kontaktelemente 8 vorgesehen, die auch bevorzugt auf einer Geraden nebeneinander angeordnet sind.

Die Teil-Außenfläche 7 ist, bezüglich ihrer Randkontur, beim Ausführungsbeispiel kreisförmig gebildet mit einem Flächenmittelpunkt M. Ein Durchmesser D entspricht beim Ausführungsbeispiel circa 4 cm.

Weiter sind zugeordnet dem Boden 10 der Teil-Außenfläche 7 Magnete 11 oder magnetisierbare Bereiche zugeordnet, die aber bevorzugt unterhalb des Bodens 10 und von außen weiter bevorzugt nicht sichtbar angeordnet sind.

Diese Magnete 11, oder magnetisierbaren Bereiche, wenn entsprechende Magnete in dem Datenspeicherelement vorgesehen sind, dienen zur Ausrichtung und Halterung des Datenspeicherelementes im mit der Küchenmaschine verbundenen Zustand.

Ein Abstand a zwischen den Magneten 11 ist bevorzugt größer als ein Abstand zwischen zwei äußersten der beim Ausführungsbeispiel vier, nebeneinander angeordneten metallischen Kontaktelemente 8.

Die Magnete 11 beziehungsweise entsprechende magnetisierbare Bereiche sind bevorzugt nahe der Randkontur der Teil-Außenfläche 7 jeweils angeordnet.

Die Magnete 11, oder magnetisierbaren Bereiche, und die Kontaktelemente befinden sich auch bevorzugt zusammengefasst in einem Flächenbereich, welcher einer Hälfte oder weniger der Gesamtfläche der Teil-Außenfläche 7 entspricht.

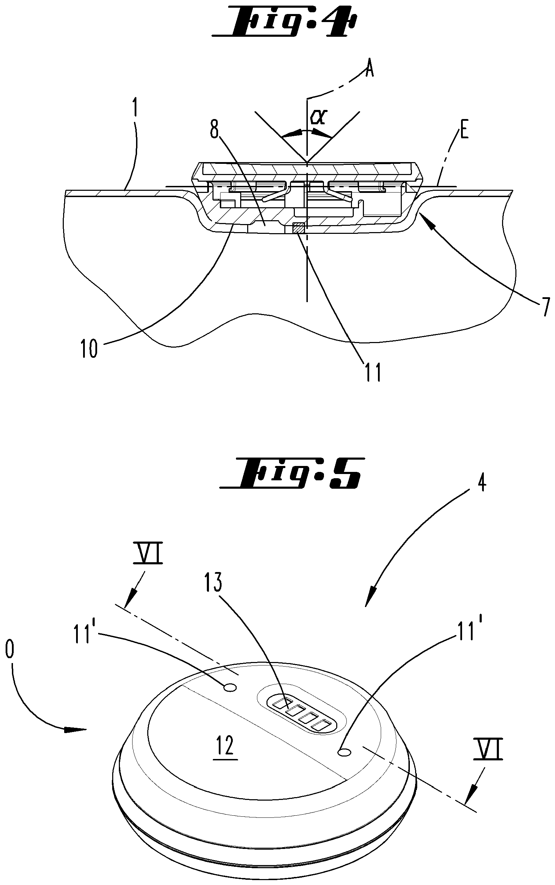

In den Figuren 4 bis 6 ist das Datenspeicherelement 4 in weiterer Einzelheit dargestellt.

Mit Bezug zu den Figur 5 und 7, 8 ist ersichtlich, dass es beim Ausführungsbeispiel einen kreisförmigen Grundriss aufweist, der aber auch beispielsweise ovalförmig oder unregelmäßig gerundet, hinsichtlich der Kontur gegebenenfalls mit geraden Zwischenabschnitten, gebildet sein kann.

Aus der auf der in Figur 5 oberen Seite, vorstehend auch als Unterseite angesprochen, weist das Datenspeicherelement 4 eine Anlagefläche 12 auf, mit der es im Verbindungszustand mit der Küchenmaschine 1 an der Teil-Außenfläche 7 anliegt. In der Anlagefläche 12 sind mehrere Kontaktflächen 13, beim Ausführungsbeispiel vier nebeneinander angeordnete Kontaktflächen 13, entsprechend den beschriebenen vier Kontaktflächen 8 an der Küchenmaschine, ausgebildet.

Entsprechend der leicht erhabenen Ausbildung des Bereiches, in welchem die Kontaktflächen 8 der Küchenmaschine angeordnet sind, sind die Kontaktflächen 13 des Datenspeicherelementes 4 in einem gegenüber der Anlagefläche 12 etwas versenkten Bereich angeordnet. Der versenkte Bereich ist nutartig gebildet. Hinsichtlich der Abmessungen wird auf die vorstehende Beschreibung auch der rippenartigen Erhöhung im Bereich der Teil-Außenfläche beziehungsweise der Außenfläche der Küchenmaschine verwiesen. Insofern ergibt sich eine komplementäre Gestaltung.

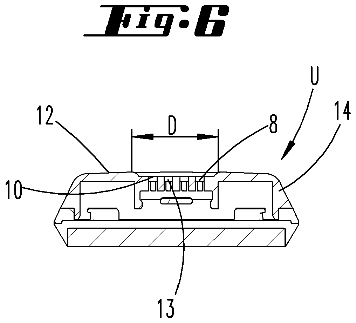

In weiterer Einzelheit, vergleiche Figuren 6 bis 8, setzt sich das Datenspeicherelement 4 aus einem als Deckelteil 14 bezeichneten Teil zusammen, in welchem die genannten Kontaktflächen 13 und die Anlagefläche 12 ausgebildet sind, einem Ringteil 15, einem Funktionsträgerteil 16 und einem Bodenteil 17. Auf dem Funktionsträgerteil 16, wobei aber auch eine andere Anordnung oder Befestigung innerhalb des Datenträgerelementes 4 möglich ist, sind beim Ausführungsbeispiel die elektronischen Bauteile, die für den Betrieb und die Nutzung des Datenspeicherelementes 4 erforderlich sind, angeordnet. Es handelt sich um Speicherelemente, insbesondere auch um einen Kryptospeicher, Leiterelemente und gegebenenfalls, in einer besonderen Ausführungsform, um Elemente, die zur Funkübertragung von Daten, etwa nach dem UMTS-Standard, erforderlich sind.

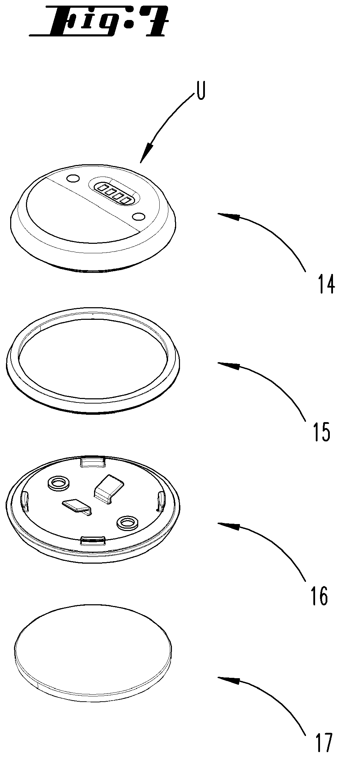

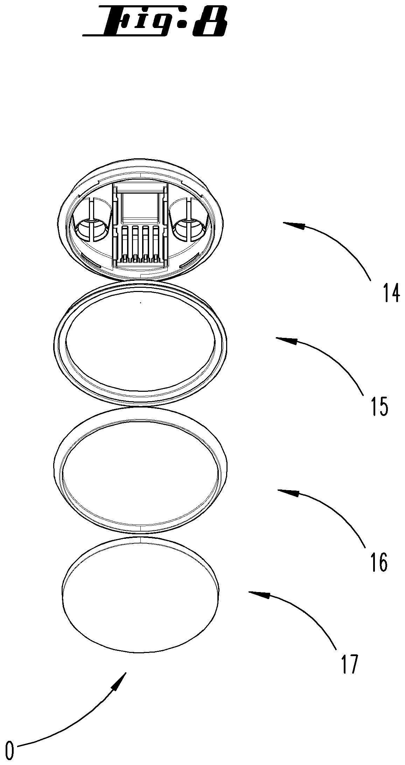

Aus der Darstellung der Figur 8, in der die Teile, die in Figur 7 sichtbar sind, von schräg unten dargestellt sind, ist ersichtlich, dass in dem Deckelteil 14 auch entsprechende Komponenten, insbesondere Leiterelemente und Leiterbahnen, zur Zusammenwirkung mit den elektronischen Komponenten, die im Funktionsträger 16 angeordnet sind, vorgesehen sind.

In dem Datenspeicherelement 4 sind auch, bevorzugt "spiegelbildlich" zu einer Ausbildung in der Außenfläche oder Teil-Außenfläche der Küchenmaschine 1 Magnete 11' oder magnetisierbare Bereiche ausgebildet.

Insgesamt ist das Datenspeicherelement 4 als Flachteil ausgebildet, mit einer Unterseite und einer Oberseite. Eine größte Grundrissabmessung der Unterseite beziehungsweise der Oberseite kann bevorzugt dem 1,5-Fachen oder mehr einer größten Dicke des Datenspeicherelementes 4 entsprechen. Die zweiten Kontaktelemente 13 sind bevorzugt in der Unterseite angeordnet. Bei an der Küchenmaschine zur Datenübertragung angeordnetem Speicherelement ist praktisch nur die Oberseite sichtbar (vergleiche Figur 3).

Die Sichtbarkeit der Oberseite kann dahingehend präzisiert werden, dass jedenfalls bezogen auf einen geraden Sichtkegel einer Kegelachse A, der sich senkrecht zu einer Mittelebene E erstreckt, in einem Kegelwinkel α von 60° oder weniger gegeben ist. Die Mittelebene E erstreckt sich ersichtlich quer zu einer Dickenerstreckung des Datenspeicherelementes 4 und bevorzugt parallel oder nahezu parallel zu der Oberseite des Datenspeicherelementes 4. Die Kegelachse A geht darüber hinaus bevorzugt durch den Flächenmittelpunkt M eines Grundrisses des Datenspeicherelementes.

Das Datenspeicherelement 4 weist in dem in Figur 4 dargestellten Kontaktzustand auch ein Griffteil auf. Das Griffteil ist hier durch die Gestaltung des Datenspeicherelementes 4 selbst gegeben, nämlich dadurch im Einzelnen, dass die Unterseite U teilweise über die umgebende Außenfläche 6 der Küchenmaschine 1 nach außen vorsteht und in eine umlaufende Kante K übergeht, von welcher beginnend die Oberseite O sich erstreckt. An der Kante K kann dann mit den Fingern einer Hand angreifend das Datenspeicherelement 4 aus der Küchenmaschine 1 wieder entnommen werden.

Ein Abstand u der Kante K über die umgebende Außenfläche 6 der Küchenmaschine 1 kann in Absolutwerten beispielsweise 0,5 bis 5 mm betragen.

Die Kante K ist bevorzugt durch das Zusammentreffen der sich im Querschnitt im Randbereich konusförmig nach oben beziehungsweise nach unten erstreckenden Randabschnitte der Konturlinie des Datenspeicherelementes gegeben. Sie ist bezüglich der Mittelebene E versetzt zur Oberseite O.

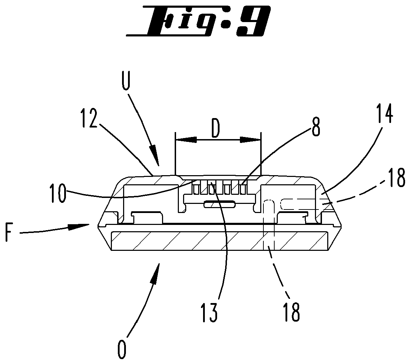

In Figur 9 ist angedeutet, dass das Datenspeicherelement 4 auch eine oder mehrere übliche, lochartig in das Innere des Datenspeicherelementes 4 ragende USB-Schnittstellen 18 aufweisen kann. Bevorzugt ist nur eine übliche USB-Schnittstelle 18 am Datenspeicherelement bei dieser Ausgestaltung verwirklicht.

Eine solche USB-Schnittstelle 18 kann insbesondere ausgehend von der Oberseite O oder einer Seitenfläche F gebildet sein. Grundsätzlich kann sie aber auch von der Unterseite U ausgehend gebildet sein.

Eine solche übliche USB-Schnittstelle 18 kann, was im Einzelnen nicht dargestellt ist, mit einem Verschlussteil versehen sein, um beim üblichen Gebrauch eine Verschmutzung möglichst zu vermeiden. Das Verschlussteil kann stopfenartig ausgebildet sein. Es kann auch nur mit einem Werkzeug lösbar vorgesehen sein. Beispielsweise kann es mit dem Datenspeicherelement verschraubt sein.

### Bezugszeichenliste:

| | | | |
|---|---|---|---|
| 1 | Küchenmaschine | A | Kegelachse |
| 2 | Rührgefäß | E | Mittelebene |
| 3 | Bedienfeld | K | Kante |
| 4 | Datenspeicherelement | M | Flächenmittelpunkt |
| 5 | Gehäuse | O | Oberseite |
| 6 | Außenfläche | U | Unterseite |
| 7 | Teil-Außenfläche | F | Seitenfläche |
| 8 | Kontaktelement | u | Abstand |
| 9 | Randkontur | x | Übergangsbereich |
| 10 | Boden | | |
| 11 | Magnet | | |
| 11' | Magnet | α | Kegelwinkel |
| 12 | Anlagefläche | | |
| 13 | Kontaktelement | | |
| 14 | Deckelteil | | |
| 15 | Ringteil | | |
| 16 | Funktionsträgerteil | | |
| 17 | Bodenteil | | |
| 18 | USB-Schnittstelle | | |

## Patentansprüche

1. Datenspeicherelement (4) zum Übertragen von Daten auf eine elektromotorisch betreibbare Küchenmaschine (1) mit mehreren voneinander gesonderten Kontaktelementen (13), mit einer Ausbildung des Datenspeicherelementes (4) insgesamt als Flachteil mit einer Unterseite und einer Oberseite, mit einer dem 1,5-Fachen oder mehr einer größten Dicke entsprechenden größten Grundrissabmessung der Unterseite beziehungsweise der Oberseite, wobei die Kontaktelemente (13) in der Unterseite angeordnet sind, **dadurch gekennzeichnet, dass** die Unterseite im Querschnitt in eine Wandungskontur übergeht, die sich in einem stumpfen Winkel zu der Konturlinie der Unterseite erstreckt und dass auch die Oberseite randseitig in dem Querschnitt in eine sich nach unten erstreckende Wandungskontur übergeht, die in einem stumpfen Winkel zu der Konturlinie der Oberseite verläuft, wobei sich im Zusammentreffen der beiden Wandkonturlinien eine umlaufende Kante zum Ergreifen des Datenspeicherelementes ergibt.

2. Datenspeicherelement nach Anspruch 1, **dadurch gekennzeichnet, dass** das Datenspeicherelement (4) einen nicht flüchtigen Speicher aufweist.

3. Datenspeicherelement nach einem der vorhergehenden Ansprüche, **dadurch gekennzeichnet, dass** das Datenspeicherelement (4) einen Kryptospeicher aufweist.

4. Datenspeicherelement nach einem der vorhergehenden Ansprüche, **dadurch gekennzeichnet, dass** das Datenspeicherelement (4) mit Ausnahme der jeweils einen Teil der Außenfläche bildenden metallischen Kontaktelemente (13) keine Schnittstellenelemente aufweist.

5. Datenspeicherelement nach einem der vorhergehenden Ansprüche, **dadurch gekennzeichnet, dass** zusätzlich zu den metallischen Kontaktelementen (13) an dem Datenspeicherelement (4) eine Standard-USB-Schnittstelle (18) ausgebildet ist.

## Claims

1. Data memory element (4) for transmitting data to a kitchen appliance (1) operable by electric motor, comprising a plurality of contact elements (13) that are separate from one another, with a design of the data memory element (4) as a whole as flat part comprising a bottom side and an upper side, with a largest layout dimension of the bottom side or of the upper side, respectively, which corresponds to 1.5-times or more of a largest thickness, wherein the contact elements (13) are arranged in the bottom side, **characterized in that**, in the cross section, the bottom side transitions into a wall contour, which extends at an obtuse angle to the contour line of the bottom side, and **in that**, on the edge side in the cross section, the upper side also transitions into a wall contour, which extends downwards and which runs at an obtuse angle to the contour line of the upper side, wherein a circumferential edge for seizing the data memory element results when the two wall contour lines meet.

2. Data memory element according to claim 1, **characterized in that** the data memory element (4) has a non-volatile memory.

3. Data memory element according to one of the preceding claims, **characterized in that** the data memory element (4) has a cryptographic memory.

4. Data memory element according to one of the preceding claims, **characterized in that**, with the exception of the metal contact elements (13), which each form part of the outer surface, the data memory element (4) does not have any interface elements.

5. Data memory element according to one of the preceding claims, **characterized in that** a standard USB interface (18) is embodied in addition to the metal contact elements (13) at the data memory element (4).

## Revendications

1. Elément de stockage de données (4) pour transmettre des données à un robot de cuisine (1) à moteur électrique, comprenant plusieurs éléments de contact (13) mutuellement séparés et l'élément de stockage de données (4) étant globalement réalisé en tant qu'élément plat avec un côté inférieur et un côté supérieur, et une dimension planimétrique maximale du côté inférieur, respectivement du côté supérieur, qui correspond à 1,5 fois ou plus d'une épaisseur maximale, dans lequel les éléments de contact (13) sont agencés dans le côté inférieur, **caractérisé en ce que** le côté inférieur, en section transversale, se raccorde à un contour de paroi qui s'étend avec un angle obtus par rapport à la ligne de contour du côté inférieur et **en ce qu'**aussi le côté supérieur du côté du bord, en section transversale, se raccorde à un contour de paroi s'étendant vers le bas et avec un angle obtus par rapport à la ligne de contour du côté supérieur, dans lequel les deux lignes de contour de paroi se rejoignent en formant une arête périphérique pour la saisie de l'élément de stockage de données.

2. Elément de stockage de données selon la revendication 1, **caractérisé en ce que** l'élément de stockage de données (4) comprend une mémoire non volatile.

3. Elément de stockage de données selon l'une des revendications précédentes, **caractérisé en ce que** l'élément de stockage de données (4) comprend une mémoire cryptographique.

4. Elément de stockage de données selon l'une des revendications précédentes, **caractérisé en ce que** l'élément de stockage de données (4) ne présente pas d'éléments d'interfaçage autres que les éléments de contact métalliques (13) qui forment chacun une partie de la surface extérieure.

5. Elément de stockage de données selon l'une des revendications précédentes, **caractérisé en ce que**, en plus des éléments de contacts métalliques (13), une interface USB standard est agencée sur l'élément de stockage de données (4).
